(19) Europäisches Patentamt
European Patent Office
Office européen des brevets

(11) EP 4 307 400 A1

(12) EUROPEAN PATENT APPLICATION
published in accordance with Art. 153(4) EPC

(43) Date of publication:
17.01.2024 Bulletin 2024/03

(51) International Patent Classification (IPC):
H01L 37/00 (2006.01)    H02N 11/00 (2006.01)

(21) Application number: 22767057.7

(52) Cooperative Patent Classification (CPC):
H02N 11/00; H10N 15/00

(22) Date of filing: 07.03.2022

(86) International application number:
PCT/JP2022/009619

(87) International publication number:
WO 2022/191101 (15.09.2022 Gazette 2022/37)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 08.03.2021 JP 2021036496

(71) Applicant: Tokyo Institute of Technology
Tokyo 152-8550 (JP)

(72) Inventors:
• MATSUSHITA, Sachiko
  Tokyo 152-8550 (JP)
• KOHATA, Haruki
  Tokyo 152-8550 (JP)
• SEKIYA, Hayato
  Tokyo 152-8550 (JP)
• IKEDA, Takumi
  Tokyo 152-8550 (JP)
• OBINATA, Mitsugu
  Chigasaki-shi, Kanagawa 253-0001 (JP)

(74) Representative: Gille Hrabal
Partnerschaftsgesellschaft mbB
Patentanwälte
Brucknerstraße 20
40593 Düsseldorf (DE)

(54) THERMOELECTRIC POWER GENERATING ELEMENT, THERMOELECTRIC POWER GENERATING BATTERY, AND POWER GENERATION STABILIZING METHOD

(57) The object of the present invention is to provide a thermal power generation battery with excellent battery characteristics.

The above problem can be solved by a thermal power generation element that does not require a temperature gradient, wherein a first part comprising a semiconductor which produce thermally excited electron and hole, a second part comprising an electrolyte in which an charge transport ion pair can be moved therein, and a third part comprising a substance that is an electrode, are in contact with each other in this order, and wherein a valance band potential of the semiconductor of the first part is positive with respect to a redox potential of a charge transport ion pair; and an ion which is more susceptible to oxidation among the two ions is oxidized at an interface between the first part and the second part; and an ion which is more susceptible to reduction among the two ions is reduced at an interface between the third part and the second part; and wherein the thermal power generation element satisfies the following formula (I):

$$L/IDT = 1\text{-}20 \quad (I)$$

wherein L is a "shortest distance between the first part and the third part", and IDT is "ion diffusion thickness."

Figure 1

EP 4 307 400 A1

**Description**

TECHNICAL FIELD

The present invention relates to the thermal power generation element and the method for stabilizing power generation.

BACKGROUND ART

Hitherto, a thermoelectric generation using the Seebeck effect has been known as thermoelectric generation using geothermal heat or exhaust heat of factories (Patent literature 1 and 2, and Non-patent literature 1). It is expected to be put into practical use in order to efficiently use thermal energy. Thermoelectric generation by the Seebeck effect uses the power generation principle in which a voltage is generated when a temperature gradient is provided on a metal or a semiconductor. Specifically, in a thermoelectric generation system, thermal energy is converted into electrical energy by applying a temperature gradient to a thermoelectric conversion element in which a $p$-type semiconductor and an $n$-type semiconductor are connected.

However, the conventional thermoelectric conversion element using the temperature gradient has problems such as the high price of the semiconductors constituting the thermoelectric conversion element, the high operating temperature range, and the low conversion efficiency. Further, there is a problem that a physical durability of a joint is weak and thus it cannot be installed in a place where vibration is applied. Furthermore, since the electric generation requires the temperature gradient, the installation location is limited. In some cases, it is necessary to use a cooling device for the temperature gradient. In particular, one dimension of the thermoelectric conversion module is used for the temperature gradient. Therefore, it is necessary to use it two-dimensionally for the heat source. In other words, it has the disadvantage that all the surrounding heat cannot be used three-dimensionally and thus the heat utilization efficiency is low.

CITATION LIST

PATENT LITERATURE

[PATENT LITERATURE 1] JP2010-147236
[PATENT LITERATURE 2] JP2003-219669
[PATENT LITERATURE 3] WO2017/038988
[PATENT LITERATURE 4] WO2020/031992

NON-PATENT LITERATURE

[NON-PATENT LITERATURE 1]Renewable and Sustainable Energy Reviews (Holland) 2014, Vol. 33, p. 371

SUMMARY OF INVENTION

TECHNICAL PROBLEM

The present inventors developed a thermal power generation element capable of converting thermal energy into electrical energy by combining a thermoelectric conversion material that generates thermally excited electrons and holes with an electrolyte (Patent Document 3). However, they thought that it is necessary to further improve the battery characteristics such as higher short-circuit current, higher discharged capacity, higher number of discharge or longer discharge time, and lower power generation temperature.

Therefore, the object of the present invention is to provide a thermal power generation battery with excellent battery characteristics.

SOLUTION TO PROBLEM

The present inventors have conducted intensive studies on a thermal power generation battery with excellent battery characteristics and surprisingly found that the battery characteristics can be improved by optimizing the thickness of the electrolyte between the semiconductor and the electrode, depending on each electrolyte.

The present invention is based on the above findings.

Namely, the present invention relates to:

[1] a thermal power generation element that does not require a temperature gradient, wherein a first part comprising a semiconductor which produce thermally excited electron and hole, a second part comprising an electrolyte in which a charge transport ion pair can be moved therein, and a third part comprising a substance that is electrode, are in contact with each other in this order, and wherein a valance band potential of the semiconductor of the first part is positive with respect to a redox potential of a charge transport ion pair; and an ion which is more susceptible to oxidation among the two ions is oxidized at an interface between the first part and the second part; and an ion which is more susceptible to reduction among the two ions is reduced at an interface between the third part and the second part; and wherein the thermal power generation element satisfies the following formula (I):

$$L/IDT = 1\text{-}20 \quad (I)$$

wherein L is the "shortest distance between the first part and the third part", and IDT is "ion diffusion thickness",

[2] the thermal power generation element of the item [1], wherein the first part, the second part and the third part are layered,

[3] the thermal power generation element of the item [1], wherein the first part, the second part and the third part are concentrically located,

[4] a thermal power generation device comprising the thermal power generation element of any one of the items claims [1] to [3],

[5] A thermal power generation battery comprising the thermal power generation element of any one of the items claims [1] to [3],

[6] a thermal power generation module comprising the thermal power generation element of any one of the items claims [1] to [3],

[7] a method for stabilizing power generation, characterizing in that a value of L/IDT (wherein L is a "shortest distance between the first part and the third part", and IDT is "ion diffusion thickness") is adjusted to 1 to 20, in the thermal power generation element that does not require a temperature gradient, wherein a first part comprising a semiconductor which produce thermally excited electron and hole, a second part comprising an electrolyte in which a charge transport ion pair can be moved therein, and a third part comprising a substance that is electrode, are in contact with each other in this order, and wherein a valance band potential of the semiconductor of the first part is positive with respect to a redox potential of a charge transport ion pair; and an ion which is more susceptible to oxidation among the two ions is oxidized at an interface between the first part and the second part; and an ion which is more susceptible to reduction among the two ions is reduced at an interface between the third part and the second part.

ADVANTAGEOUS EFFECTS OF INVENTION

According to the thermal power generation element of the present invention, it shows excellent discharge capacity, short-circuit current, number of discharges, or discharge time. Further, thermal power generation element of the present invention can generate power in low or high temperature ranges, extending the range of temperatures over which power can be generated.

BRIEF DESCRIPTION OF THE DRAWINGS

FIG. 1 is a schematic diagram of the thermal power generation element of the present invention.

FIG. 2 is a schematic diagram of the specific embodiment of thermal power generation element of the present invention.

FIG. 3 is a graph plotting the measured AC impedance for the thermal power generation element of the present invention.

FIG. 4 is a schematic diagram (A), and graphs showing open voltage (B) and obtained voltage change (C) at 80°C for the sheet type cell of Example 1.

FIG. 5 is a schematic diagram (A), and graphs showing power generation characteristics (B, C) and temperature variation of ion diffusion thickness (D) of the interdigitated array electrode in Example 2.

FIG. 6 is a graph showing the relationship between short-circuit current and L/IDT for the batteries in Examples 1 and 2.

FIG. 7 is a graph showing the relationship between discharged capacity and L/IDT for the batteries in Examples 3 and 4.

FIG. 8 is graphs showing discharge time (A), open voltage (B), and the relationship between L/IDT and discharge time (C) for the cell in Example 5.

FIG. 9 is a graph showing the relationship between short-circuit current and L/IDT at 80°C for the cell in Example 6.

FIG. 10 is a graph showing the relationship between short-circuit current and L/IDT at 80°C for the cell in Example 7.

FIG. 11 is a graph showing the relationship between L/IDT and electric capacity at 80°C of the cell in Example 8.

FIG. 12 is a graph showing the battery characteristics at 30°C and at 80°C of the cell in Example 9.

## DESCRIPTION OF EMBODIMENTS

[1] Thermal power generation element and thermal power generation battery

The thermal power generation element does not require a temperature gradient, and a first part comprising a semiconductor which produce thermally excited electron and hole, a second part comprising an electrolyte in which a charge transport ion pair can be moved therein, and a third part comprising a substance that is electrode, are in contact with each other in this order, and a valance band potential of the semiconductor of the first part is positive with respect to a redox potential of a charge transport ion pair; and an ion which is more susceptible to oxidation among the two ions is oxidized at an interface between the first part and the second part; and an ion which is more susceptible to reduction among the two ions is reduced at an interface between the third part and the second part. Further, the thermal power generation element satisfies the following formula (I):

$$L/IDT = 1\text{-}20 \qquad (I)$$

wherein L is a "shortest distance between the first part and the third part", and IDT is "ion diffusion thickness."

<<First part>>

The first part is not particularly limited, as long as it comprises a semiconductor which produce thermally excited electron and hole (hereinafter, sometimes referred to as a first semiconductor). The semiconductor which produce thermally excited electron and hole is a thermoelectric conversion material. The valance band potential of the semiconductor is positive with respect to a redox potential of the charge transport ion pair. Therefore, one ion that is more susceptible to oxidation among the charge transport ion pair is oxidized at an interface between the first part and the second part, and it becomes the other ion. A potential difference between the redox potential of the charge transport ion pair in the second part and the valance band potential of the semiconductor is not limited, as long as the effect of the present invention can be achieved, but is preferably 0 to 1.0V, more preferably 0.05 to 0.5V, further preferably 0.05 to 0.3V. For example, the potential difference between the redox potential of $CuZr_2(PO_4)_3$ (Cusicon, a copper ion conductor) and the valence band potential of $\beta$-$FeSi_2$ is about 0.05V. If a redox potential of the charge transport ion pair and a valance band potential of the semiconductor have been measured, the person skilled in the art can select an appropriate ion for the semiconductor, and select an electrolyte to which the ion can be moved, according to the values of redox potential and valance band potential. Regarding materials for which a valence band potential of the semiconductor and a redox potential of the charge transport ion pair are unknown, it is possible to measure the valence band potential of the semiconductor and the redox potential of the ions. Therefore, a person skilled in the art can select an appropriate electrolyte of the charge transport ion pair according to the selected semiconductor.

(First semiconductor)

The first semiconductor is not limited, as long as it can generate thermally excited electrons and holes by being applied with appropriate temperatures, but includes, for example, metal semiconductors, tellurium compound semiconductors, silicon-germanium (Si-Ge) compound semiconductors, silicide compound semiconductors, skutterudite compound semiconductors, clathrate compound semiconductors, Heusler compound semiconductors, half-Heusler compound semiconductors, metal oxide semiconductors, organic semiconductors, sulfide semiconductors, and other semiconductors. The semiconductors used in the present invention function as thermoelectric conversion materials.

As the metal semiconductor, there may be mentioned Si semiconductor, and Ge semiconductor.

As the tellurium compound semiconductors, there may be mentioned Bi-Te compounds (for example, $Bi_2Te_3$, $Sb_2Te_3$, $CsBi_4Te_6$, $Bi_2Se_3$, $Bi_{0.4}Sb_{1.6}Te_3$, $Bi_2(Se, Te)_3$, $(Bi, Sb)_2(Te, Se)_3$, $(Bi, Sb)_2Te_3$, or $Bi_2Te_{2.95}Se_{0.05}$), Pb-Te compounds (for example, PbTe, or $Pb_{1-x}Sn_xTe$), SnTe, Ge-Te, $AgSbTe_2$, Ag-Sb-Ge-Te compounds (for example, GeTe-$AgSbTe_2$(TAGS)), $Ga_2Te_3$, $(Ga_{1-x}In_x)_2Te_3$, $Tl_2Te$-$Ag_2Te$, $Tl_2Te$-$Cu_2Te$, $Tl_2Te$-$Sb_2Te_3$, $Tl_2Te$-$Bi_2Te_3$, $Ti_2Te$-GeTe,

$Ag_8Tl_2Te_5$, $Ag_9TlTe_5$, $Tl_9BiTe_6$, $Tl_9SbTe_6$, $Tl_9CuTe_5$, $Tl_4SnTe_3$, $Tl_4PbTe_3$, or $Tl_{0.02}Pb_{0.98}Te$.

As the silicon-germanium (Si-Ge) compound semiconductors, there may be mentioned $Si_xGe_{1-x}$, or SiGe-GaP.

As the silicide compound semiconductors, there may be mentioned $\beta$-$FeSi_2$ compounds (for example, $\beta$-$FeSi_2$, $Fe_{1-x}Mn_xSi_2$, $Fe_{0.95}Mn_{0.05}Si_{(2-y)}Al_y$, $FeSi_{(2-y)}Al_y$, $Fe_{1-y}Co_ySi_2$), $Mg_2Si$, $MnSi_{1.75-x}$, $Ba_8Si_{46}$, $Ba_8Ga_{16}Si_{30}$, or $CrSi_2$.

As the skutterudite compound semiconductors, there may mentioned compounds represented by formula $TX_3$ (wherein T is a transition metal selected from the group consisting of Co, Fe, Ru, Os, Rh, and Ir, and X is a pnictogen selected from the group consisting of P, As, and Sb), and compounds represented by formula $RM_4X_{12}$ (wherein R is a rare earth selected from the group consisting of Sc, Y, La, Ce, Pr, Nd, Pm, Sm, Eu, Gd, Tb, Dy, Ho, Er, Tm, Yb, and Lu, M is selected from the group consisting of Fe, Ru, Os, and Co, and X is selected from the group consisting of P, As, and Sb) which are derivatives of the above compounds, $Yb_yFe_{4-x}Co_xSb_{12}$, $(CeFe_3CoSb_{12})_{1-x}(MoO_2)_x$ or $(CeFe_3CoSb_{12})_{1-x}(WO_2)_x$.

As the clathrate compound semiconductors, there may be mentioned compounds represented by the formula $M_8X_{46}$ (M is selected from the group consisting of Ca, Sr, Ba, and Eu, and X is selected from the group consisting of Si, Ge, and Sn) and compounds represented by the formula $(II)_8(III)_{16}(IV)_{30}$ (wherein, II is a group II element, III is a group III element, and IV is a group IV element) which are derivatives of the above compounds. As the compounds of the formula $(II)_8(III)_{16}(IV)_{30}$, there may be mentioned, for example, $Ba_8Ga_xGe_{46-x}$, $Ba_{8-x}(Sr, Eu)_xAu_6Ge_{40}$, $Ba_{8-x}Eu_xCu_6Si_{40}$).

As Heusler compound semiconductors, there may be mentioned $Fe_2VAl$, $(Fe_{1-x}Re_x)_2VAl$, or $Fe_2(V_{1-x-y}Ti_xTa_y)Al$.

As the half-Heusler compound semiconductor, there may be mentioned compounds represented by the formula MSiSn (wherein M is selected from the group consisting of Ti, Zr, and Hf), compounds represented by formula MNiSn (wherein M is Ti or Zr), compounds represented by formula MCoSb (wherein M is selected from the group consisting of Ti, Zr, and Hf), or compounds represented by the formula LnPdX (where Ln is selected from the group consisting of La, Gd, and Er, and X is Bi or Sb).

As the metal oxide semiconductors, there may be mentioned $In_2O_3$-$SnO_2$, $(CaBi)MnO_3$, $Ca(Mn, In)O_3$, $Na_xV_2O_5$, $V_2O_5$, $ZnMnGaO_4$ and their derivatives, i.e. $LaRhO_3$, $LaNiO_3$, $SrTiO_3$, $SrTiO_3$:Nb, $Bi_2Sr_2Co_2O_y$, $Na_xCoO_2$, $NaCo_2O_4$, $CaPd_3O_4$, compounds represented by the formula $Ca_aM^1_bCo_cM^2_dAg_eO_f$ (wherein $M^1$ is one or more elements selected from the group consisting of Na, K, Li, Ti, V, Cr, Mn, Fe, Ni, Cu, Zn, Pb, Sr, Ba, Al, Bi, Y and rare earths, $M^2$ is one or more elements selected from the group consisting of Ti, V Cr, Mn, Fe, Ni, Cu, Mo, W, Nb, Ta and Bi, and $2.2 \leqq a \leqq 3.6$, $0 \leqq b \leqq 0.8$, $2 \leqq c \leqq 4.5$, $0 \leqq d \leqq 2$, $0 \leqq e \leqq 0.8$, $8 \leqq f \leqq 10$), ZnO, $Na(Co, Cu)_2O_4$, ZnAlO, $Zn_{1-x}Al_xO$, or $La_{1.98}Sr_{0.02}CuO_4$.

As the organic semiconductors, there may be mentioned an organic perovskite, polyaniline, polyacetylene, polythiophene, polyalkylthiophene, or polypyrrole.

As the sulfide semiconductors, there may be mentioned $Ag_2S$, ZnS, CdS, or ZnS.

As the other thermoelectric conversion compounds, there may be mentioned, an alloy containing Co and Sb (for example, $CoSb_3$, $CeFe_3CoSb_{12}$, $CeFe_4CoSb_{12}$, or $YbCo_4Sb_{12}$), an alloy containing Zn and Sb (for example, ZnSb, $Zn_3Sb_2$, or $Zn_4Sb_3$), an alloy containing Bi and Sb (for example, $Bi_{88}Sb_{12}$), $CeInCu_2$, $(Cu, Ag)_2Se$, $Gd_2Se_3$, CeRhAs, or $CeFe_4Sb_{12}$, $Li_{7.9}B_{105}$, $BaB_6$, $SrB_6$, $CaB_6$, AlPdRe compound (For example, $Al_{71}Pd_{20}(Re_{1-x}Fe_x)_9$), AlCuFe quasicrystal, $Al_{82.6-x}Re_{17.4}Si_x$1/1-cubic approximants crystal, $YbAl_3$, $YbMn_xAl_3$, $\beta$-CuAgSe, $B_4C/Ba_3C$, $(Ce_{1-x}La_x)Ni_2$, or $(Ce_{1-x}La_x)In_3$.

The first part may further have an electron transport material in addition to the first semiconductor. The electron transport material is located on the opposite side of the contact surface of the semiconductor with the second part. The electron transport material may include a semiconductor or a metal. The conduction band of the electron transport material is the same as or positive to the conduction band potential of the semiconductor (first semiconductor) that produces thermally excited electrons and holes.

The conduction band of the electron-transport material is not particularly limited as long as it is the same as or positive to the conduction band potential of the first semiconductor. The electron transport material includes a semiconductor or a metal. As specific electron transport materials, there may be mentioned, for example, an n-type metal oxide containing at least one selected from the group consisting of niobium, titanium, zinc, tin, vanadium, indium, tungsten, tantalum, zirconium, molybdenum and manganese, *n*-type metal sulfides, alkali metal halides, alkaline metals *n*-type metal oxides, a *n*-type metal sulfide, an alkali metal halide, an alkali metal halide, or an electron-transporting organic material. More specifically, for example, there may be mentioned, titanium oxide, tungsten oxide, zinc oxide, niobium oxide, indium oxide, tin oxide, gallium oxide, tin sulfide, indium sulfide, zinc sulfide, or $SrTiO_3$. As electron-transporting organic materials, *n*-type conductive polymers, *n*-type low-molecular-weight organic semiconductors, $\pi$-electron conjugated compounds, surfactants, specifically, oxadiazole derivatives, triazole derivatives, perylene derivatives, or quinolinol metal complexes, cyanogen-containing polyphenylenevinylene, boron-containing polymers, bathocuproin, bathophenanthline, aluminum hydroxyquinolinato, oxadiazole compounds, benzoimidazole compounds, naphthalene tetracarboxylic acid compounds, perylene derivatives, phosphine oxide compounds, phosphine sulfide compounds, fluoro group containing phthalocyanine, fullerene and its derivatives, phenylene vinylene polymers, and perylene tetracarboxylic acid imide derivatives.

The potential difference between the conduction band of the electron-transport material and the conduction band potential of the first semiconductor is not limited, as long as the effect of the present invention can be achieved, but preferably 0.01 to 1V, more preferably 0.01 to 0.5V, further preferably 0.01 to 0.3V, most preferably 0.05 to 0.2V. For example, the conduction band potential of $n$-type silicon with respect to the conduction band potential of $\beta$-FeSi$_2$, i.e., the potential difference of the conduction band is about 0.01V.

When the conduction band potential of the first semiconductor and the conduction band of the electron transport material have been measured, the skilled person may select an appropriate electron transport material for the first semiconductor in the first part, according to the values of those potentials.

When the conduction band potential of the semiconductor and the conduction band of the electron-transport material are unknown, it is possible to measure their potentials, for example, by electrochemical measurements or by inverse photoemission spectroscopy (XPS). Therefore, a person skilled in the art can select an appropriate electron transport material according to the first semiconductor in the first part to be used in the thermal power generation element.

The first semiconductor in the first part can be prepared, for example, by squeegee method, screen printing method, spark plasma sintering method, compression molding, sputtering method, vacuum deposition method, or spin coating method. In the case of spin-coating method, the first semiconductor can be prepared by dispersing $\beta$-FeSi$_2$ in a polar solvent such as acetone and spin-coating the solution onto the electron transport material or the second part. Alternatively, FeSi$_2$ can be prepared by the spark plasma sintering method, and the resulting FeSi$_2$ powder and conductive binder (e.g., high-temperature conductive coating) can be squeegeed onto the electron transport material or the second part.

In addition, the electron transport materials can also be prepared, for example, by squeegee method, screen printing method, sputtering method, vacuum deposition method, single crystal growth method, or spin coating method, for example. In the case of the spin-coating method, the oxadiazole derivative is dissolved in a polar solvent such as acetone, and the resulting solution is spin-coated onto the substrate, the first semiconductor, or the like, to prepare the electron transport material. For example, $n$-type silicon (described below) can be obtained by the single crystal growth method, and the first semiconductor can be laminated using this $n$-type silicon as a substrate.

The first part of the thermal power generation element of the present invention can contain other components, as long as the first semiconductor can generate a sufficient number of thermally excited electrons and holes for power generation by being applied an appropriate temperature. The above components is not limited, but include binders (polyvinyl alcohol, methylcellulose, acrylic resin, agar, etc.) and sintering aids (magnesium oxide, yttrium oxide, calcium oxide, etc.) that assist in forming the first semiconductor. Solvents used in the preparing process may also remain. The first part used in the present invention substantially functions as a thermoelectric conversion layer.

<<Second part>>

The second part is not limited, as long as it contains an electrolyte in which the charge transport ion pair can move. The electrolyte includes, for example, a solid electrolyte or an electrolyte solution. The electrolyte is not limited as long as it can transport the two ions of the charge transport ion pair.

That is to say, the electrolyte contained in the second part is not limited, as long as the redox potential is at an appropriate position with respect to the valance band potential of the first semiconductor used in the thermal power generation element and the charge transport ion pair can move back and forth in the electrolyte. The electrolyte is preferably stable physically and chemically at the temperature at which the first semiconductor produces a sufficient number of thermally excited electrons and holes for power generation.

The electrolyte can be a solid electrolyte or an electrolyte solution (liquid electrolyte), depending on its embodiment. The electrolyte can be in the state of electrolyte solution (liquid electrolyte) or in the state of solid electrolyte, depending on the temperature. That is to say, the compounds included in the electrolyte solution (liquid electrolyte) and the compounds included in the solid electrolyte may be overlap. Further, the electrolytes include molten salts, ionic liquids, or deep eutectic solvents. The molten salt is a salt composed of cations and anions, and it is in a molten state. Among molten salts, those with relatively low melting points (e.g., those below 100°C or 150°C) are called ionic liquids. In the present specification, molten salts in solid state are also referred to as solid electrolytes and those in solution form are referred to as electrolyte solutions (liquid electrolytes). Hereinafter, electrolyte solutions (liquid electrolytes), solid electrolytes, and molten salts are specifically exemplified, and these may be sometimes overlapped.

The electrolyte solution is a solution (liquid) state electrolyte at the temperature at which the semiconductor of the first part produces a sufficient number of thermally excited electrons and holes for generate electricity. Specifically, the electrolyte solution is not limited, but includes methoxide ion, hydrogen ion, ammonium ion, pyridinium ion, lithium ion, sodium ion, potassium ion, calcium ion, magnesium ion, aluminum ion, iron ion, copper ion, zinc ion, cobalt ion, fluorine ion, cyanide ion, thiocyanate ion, chloride ion, acetate ion, sulfate ion, carbonate ion, phosphate ion, bicarbonate ion, and bromine ion.

The solid electrolyte is a solid state electrolyte in which charge transport ion pair can move inside thereof at a temperature at which the semiconductor of the first part produces a sufficient number of thermally excited electrons and holes for power generation. The high-temperature solid electrolyte can be used in thermal power generation element in which a thermal power generation element body that generate thermally excited electrons and holes at high temperatures is used.

Specifically, the solid electrolyte is not limited, but includes sodium ion conductor, copper ion conductor, lithium ion conductor, silver ion conductor, hydrogen ion conductor, strontium ion conductor, aluminum ion conductor, fluorine ion conductor, chlorine ion conductor, or oxide ion conductor. As the specific solid electrolyte, for example, there may be mentioned, $RbAg_4I_5$, $Li_3N$, $Na_2O \cdot 11Al_2O_3$, Sr-$\beta$ alumina, $Al(WO_4)_3$, $PbF_2$, $PbCl_2$, $(ZrO_2)_{0.9}(Y_2O_3)_{0.1}$, $(Bi_2O_3)_{0.75}(Y_2O_3)_{0.25}$, $CuZr_2(PO_4)_3$, $CuTi_2(PO_4)_3$, $Cu_xNb_{1-x}Ti_{1+x}(PO_4)_3$, $H_{0.5}Cu_{0.5}Zr_2(PO_4)_3$, $Cu_{1+x}Cr_xTi_{2-x}(PO_4)_3$, $Cu_{0.5}TiZr(PO_4)_3$, $CuCr_2Zr(PO_4)_3$, $Cu_2ScZr(PO_4)_3$, $CuSn_2(PO_4)_3$, $CuHf_2(PO_4)_3$, $Li_7La_3Zr_2O_{12}$, $Li_7La_3Zr_{2-x}Nb_xO_{12}$, $Li_7La_3Zr_{2-x}TaxO_{12}$, $Li_5La_3Ta_2O_{12}$, $Li_{0.33}La_{0.55}TiO_3$, $Li_{1.5}Al_{0.5}Ge_{1.5}P_3O_{12}$, $Li_{1.3}Al_{0.3}Ti_{1.7}P_3O_{12}$, $Li_3PO_4$(LiPON), $Li_4SiO_4$-$Li_3PO_4$, $Li_4SiO_4$, $Li_3BO_3$, or the like.

In addition, molten salts can be used as solid electrolytes or electrolyte solutions. In the case of the thermal power generation element used at relatively low temperatures, ionic liquids can also be used. Deep Eutectic Solvents (DES) can be used as ionic liquids.

As the molten salt, there may be mentioned a molten salt comprising at least one cation selected from the group consisting of imidazolium cation, pyridinium cation, piperidinium cation, pyrrolidinium cation, phosphonium cation, morpholinium cation, sulfonium cation and ammonium cation, and at least one anion selected from the group consisting of carboxylic acid anion, sulfonic acid anion, halogen anion, tetrafluoroborate, hexafluorophosphate, bis(trifluoromethanesulfonyl)imide, and bis(fluorosulfonyl)imide. The electrolyte in the present invention functions as a hole-transmitting material.

In the present specification, the term " charge transport ion pair " means an ion-pair consisting of two stable ions with different valence, wherein one ion is oxidized or reduced to become the other ion, and which can carry electrons and holes. They can be ions of the same element with different valence.

For example, in the case of copper ions, monovalent copper ion and divalent copper ion are preferable, and in the case of iron ions, divalent iron ion and trivalent iron ion are preferable. For example, CuCl, CuBr, copper(I) acetate, copper(I) iodide, or copper(I) sulfate can be used as the monovalent copper ion. $CuCl_2$, $CuTSFI_2$, copper(II) acetate, copper(II) sulfate or copper(II) acetylacetonate can be used as the divalent copper ion. $Fe(C_5H_5)_2$ (ferrocene), $K_4[Fe(CN)_6]$, iron(II) acetylacetonate, iron(II) chloride, iron(II) sulfate or iron(II) acetate can be used as the divalent iron ion. $FeCl_3$, $K_3[Fe(CN)_6]$, Fe(III) acetylacetonate or Fe(III) sulfate can be used as trivalent iron ion.

The oxidation reaction of the more easily oxidized ion of the two ions occurs at the interface between the first part and the second part, and the reduction reaction of the more easily reduced ion of the two ions occurs at the interface between the third part and the second part.

In the present invention, the valance band potential of the semiconductor of the first part is positive with respect to a redox potential of the charge transport ion pair. Therefore, at the interface between the first part and the second part (electrolyte) of the present invention, the more easily oxidized ion of the charge transport ion pair is oxidized and becomes the other ion.

The potential difference between the redox potential of the charge transport ion pair in the electrolyte and the valance band potential of the thermoelectric conversion material is not limited, as long as the effect of the present invention can be achieved, but is preferably 0 to 1.0 V, more preferably 0.05 to 0.5 V, and more preferably 0.05 to 0.3 V. For example, the potential difference of the redox potential of $CuZr_2(PO_4)_3$ (Cusicon, a copper ion conductor) with respect to the valance band potential of $\beta$-$FeSi_2$ is about 0.05V.

For materials for which the redox potential of the charge transport ion pair and the valance band potential of the thermoelectric conversion material have been measured, the person skilled in the art can select appropriate ions for the thermoelectric conversion material according to the values of the redox potential and valance band potential, and select an electrolyte to which the ions can move. For materials for which the valence band potential of the first semiconductor and the redox potential of the charge transport ion pair are unknown, it is possible to measure the valance band potential of the first semiconductor and the redox potential of the ions. Therefore, a person skilled in the art can select an appropriate charge transport ion pair and electrolyte according to the selected first semiconductor.

The thermal power generation battery of the present invention preferably comprises an alkali metal ion in the second part as an additive (Patent literature 4). As the alkali metal ion, there may be mentioned lithium ion, sodium ion, potassium ion, rubidium ion, cesium ion, or franchium ion, but lithium ion, sodium ion, or potassium ion is preferable. It is possible to extend the battery life by containing alkali metal ions, and to restore the discharge characteristics by leaving it in a heat source. The alkali metal ion is not limited but may be added to the electrolyte in the form of a halide, perchloric acid (such as, $LiClO_4$), sulfate, or strong acid salt. For example, alkali metal compounds can be used in various forms as long as they do not degrade the solvent.

Halogen forming the halide with the metal ion includes fluorine, chlorine, bromine, iodine, or astatine. For example, a compound of the alkali metal ion and chlorine includes LiCl, NaCl, KCl, RbCl, CsCl, or FrCl.

The additive amount of alkali metal compound is not particularly limited, as long as it can extend battery life, but is, for example, 0.001 to 100 parts by weight, preferably 0.01 to 10 parts by weight, and more preferably 0.03 to 0.1 parts by weight with respect to 100 parts by weight of electrolyte. The above range provides a particularly excellent effect of extending battery life.

The second part may contain substances other than the solid electrolyte or the electrolyte solution. The other substances are not limited, but for example, there may be mentioned polar solvents that dissolve or disperse electrolyte (water, methanol, toluene, tetrahydrofuran, or the like), binders that bind the electrolyte (polyvinyl alcohol, methylcellulose, acrylic resin, agar, or the like), sintering aids that help a forming of hole-transmitting materials (magnesium oxide, yttrium oxide, calcium oxide, or the like), when the second part is prepared.

The second part can be prepared, for example, by squeegee method, screen printing method, sputtering method, vacuum deposition method, sol-gel method, or spin coating method. For example, $CuZr_2(PO_4)_3$ is prepared by the sol-gel method. The resulting sol can be prepared as the second part by the squeegee method. When the electrolyte is an electrolyte solution (liquid electrolyte), the second part is a liquid phase. When the second part is a liquid phase, the second part of the thermal power generation element is preferably prepared at the time of fabrication of the thermal power generation device or a thermo battery, or the thermal power generation module. That is to say, the second part can be prepared by providing a tank for holding the electrolyte solution (liquid electrolyte).

<<Third part>>

The third part is not particularly limited, as long as it contains a substance which is an electrode. The substance to be electrode is not limited, so long as it can transport electrons, but for example, includes fluorine-doped tin oxide (FTO), tin-doped indium oxide (ITO), antimony-doped tin oxide (ATO), aluminum-doped zinc oxide (AZO), gallium-doped zinc oxide (GZO), zinc oxide (ZnO), indium oxide (($In_2O_3$), tin oxide ($SnO_2$), IZO (In-Zn-O), or IGZO (In-Ga-Zn-O). In addition, there may be mentioned metals that do not react with electric charge transport ion pair, such as titanium, gold, platinum, silver, copper, tin, tungsten, niobium, tantalum, stainless steel, aluminum, graphene, molybdenum, indium, vanadium, rhodium, niobium, chromium, nickel, carbon, their alloys or combinations thereof. The third part may be provided as a layer or in the form of a conducting wire. In the case of the layer, it can be manufactured by a vacuum deposition method or a spin coating method

When an appropriate temperature is applied to the first semiconductor, a sufficient number of thermally excited electrons and holes are produced to generate electricity. The redox potential of the electrolyte contained in the second part is negative with respect to the valance band potential of the first semiconductor in the first part, and thus holes are transported from the first part to the third part (sometimes referred to the positive electrode). That is to say, ionic redox occurs in the electrolyte, and electrons are transported from the third part (positive electrode) to the first part, and holes are transported from the first part to the third part (positive electrode). By these mechanisms, electrons are moved and electricity can be generated

The thermal power generation element of the present invention satisfies the following formula (I).

$$L/IDT = 1\text{-}20 \quad (I)$$

wherein L is a "shortest distance between the first part and the third part", and IDT is "ion diffusion thickness"

The lower limit of the L/IDT is 1 or more, preferably 1.5 or more, and more preferably 2 or more. The upper limit of the L/IDT is 20 or less, preferably 15 or less, more preferably 10 or less, more preferably 8 or less, and most preferably 5 or less. The lower limits and upper limits can be combined as necessary.

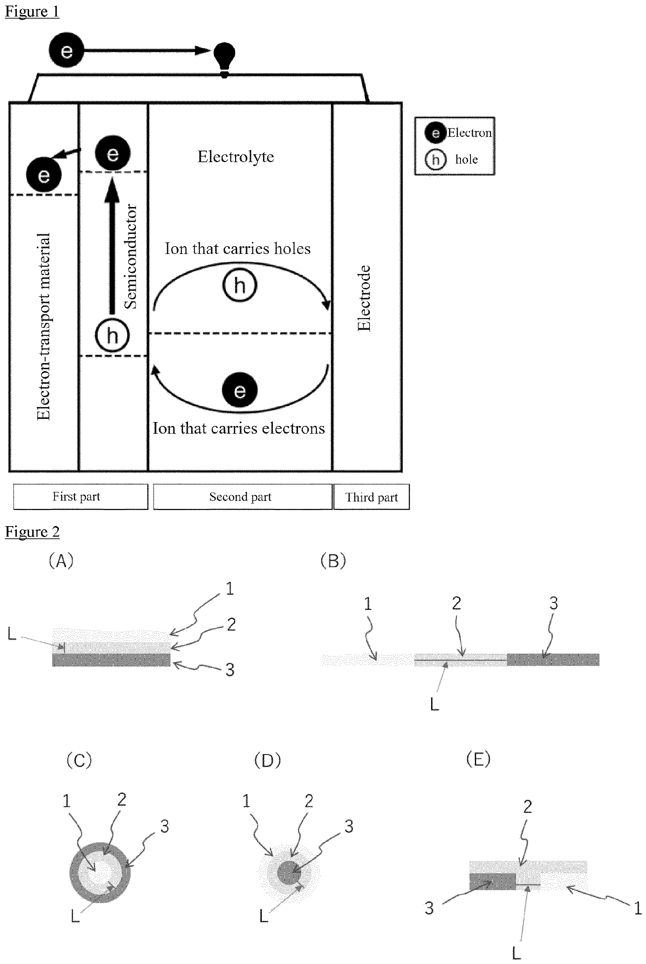

The term "shortest distance between the first part and the third part" is explained using Figure 2.

Figure 2 schematically shows several specific embodiments of the thermal power generation element of the present invention. For example, in the thermal power generation element of the present invention, the first part, the second part, and the third part can be laminated in layers (Figure 2A). In this case, the thickness L of the second part is " shortest distance between the first part and the third part."

As shown in Figure 2B, it is also possible to arrange the first part, the second part, and the third part on one plane. This arrangement is also included in the embodiment wherein the first part, the second part, and the third part are laminated in layers. In this case, the thickness L (width) of the second part which is sandwiched between the first part and third part, is the "shortest distance between the first part and the third part."

In the thermal power generation element of the present invention, the first part, the second part, and the third part may be concentrically located (Figure 2C and 2D). For example, as shown in Figure 2C, the first part can be placed in the center, the second part can be placed around it, and the third part can be placed around it. As shown in Figure 2D, the third part can be placed in the center, the second part can be placed around it, and the first part can be placed around it. In both cases, the thickness L (the thickness of the thinnest part) of the second part between the first part and the third part is the "shortest distance between the first part and the third part."

In the thermal power generation element of the present invention, the second part can be arranged in a T-shape, as shown in Figure 2E. That is, the lower part of the T-shape of the second part can be placed between the first part and the third part. In this case, the thickness L of the lower second part between the first and the third part is the "shortest distance between the first part and the third part."

These thicknesses L can be measured by a caliper, a stylus profiler, or an optical microscope.

The "ion diffusion thickness" is an intrinsic value that can be calculated from the redox ions, electrolyte, and temperature of the second part. However, it is preferable to obtain it by measurement since different values may be calculated by different models. The "ion diffusion thickness" can be measured as follows.

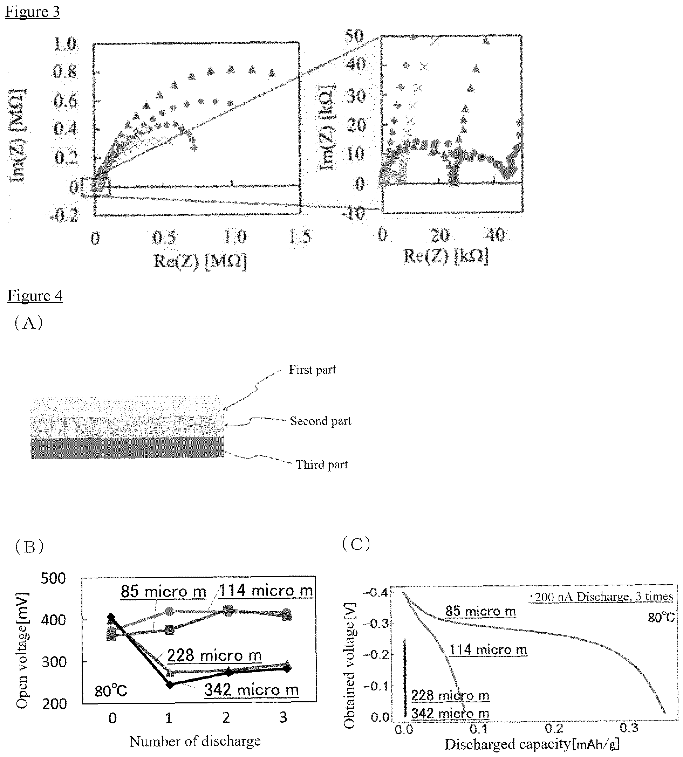

The thermal power generation element (battery) having the first part, the second part, and the third part, is measured for alternating current impedance (AC impedance). When the measured AC impedance values are plotted, as shown in Figure 3, for example, a graph of the shape wherein a curve and a semicircle are combined, or a graph of shape wherein a curve and a curve combined, is obtained. From this plotted graph, the fitting equation of the equivalent circuit is created.

Using the obtained fitting equation and the following equation (II), the ion diffusion thickness IDT (corresponding to "$\delta$" in the following equation) is calculated.

[Equation 1]

$$Z_w = \frac{RT}{nFc^{bulk}} \frac{1}{nF\sqrt{j\omega D}} \tanh\left(\sqrt{\frac{j\omega}{D}}\delta\right) \qquad (\mathrm{I\,I})$$

R: gas constant, $T$: temperature, $n$: number of reacting electrons, F: Faraday constant, $c^{bulk}$: bulk concentration of electrolyte ions, j: imaginary number, $\omega$: frequency, $D$: diffusion coefficient, $\delta$: ion diffusion thickness

Using the ion diffusion thickness IDT obtained by the above calculation, the value of "L/IDT" can be calculated from the shortest distance L between the first part and the third part and the ion diffusion thickness IDT.

The thermal power generation device, the thermal power generation battery, and the thermal power generation module of the present invention comprise the thermal power generation element of the present invention, and preferably comprise a negative electrode on the outside of the first part. The electron-transport material of the thermal power generation element used in the thermal power generation device, the thermal power generation battery, and the thermal power generation module of the present invention, can play the role of negative electrode. The third part plays the role of negative electrode, as mentioned above. Even if there is no third part, the second part can play the role of a positive electrode.

In the present specification, the term " thermal power generation battery " means a battery that comprises the thermal power generation element of the present invention and generates electricity when a temperature at which thermally excited electrons and holes can be generated, is applied to the first semiconductor of the thermal power generation element.

Thermal generation can be conducted using the thermal power generation device, the thermal power generation battery, and the thermal power generation module of the present invention. For example, power can be generated by the process of installing the thermal power generation module or the like in a heat-generating place, and heating the thermal power generation module by heat to generate electric power.

In the process of installing the thermal power generation module or the like, the thermal power generation module of the present invention is installed at the heat-generating place. The heat-generating place is not particularly limited, as long as, in the heat-generating place, heat above the temperature that produces a sufficient number of excited electrons and holes for power generation, is generated. As the heat-generating place, there may be mentioned a geothermal heat generation site or an exhaust heat generation site such as a factory. The geothermal heat is not limited to heat in soil, but includes hot water or steam heated by geothermal heat. Further, the geothermal heat includes hot water or steam in oceans, lakes, rivers, or the like heated by geothermal heat. Exhaust heat is not limited, but includes, for example, exhaust heat from steel furnaces, waste incineration plants, electric substations, subways, automobiles or the like. In particular, exhaust heat from steel furnaces and waste incineration plants, which have large amounts of energy, is released without being utilized. Therefore, it is preferable that it is reused by the thermal generation method of the present invention.

Furthermore, the thermal power generation element of the present invention can generate electricity at low temperatures (for example, room temperature) and can be used in a variety of devices that are used at room temperature.

In the power generation process, the thermal power generation module is heated to generate electric power. The heat generated from the heat generation site heats the thermoelectric conversion material of the thermal power generation module above the temperature at which a sufficient number of excited electrons and holes are produced for power generation, and thereby generating electric power from the thermal power generation module.

The temperature of power generation is preferably the temperature at which the density of thermally excited electrons becomes $10^{15}/m^3$, more preferably $10^{18}/m^3$ or more, more preferably $10^{20}/m^3$ or more, and most preferably $10^{22}/m^3$ or more. The temperature of power generation basically depends on the first semiconductor, but a person skilled in the art can determine the temperature of power generation from the common technical knowledge in the field of the present invention and the description in the present specification. The temperature of power generation in the present invention is preferably the temperature at which charge transport ion pairs can move back and forth in the electrolyte.

Specifically, the temperature is not limited, but is, for example, 5°C or more, preferably 10°C or more, more preferably 20°C or more, and even more preferably 30°C or more. The upper limit of temperature is also not limited, as long as the charge transport ion pair can move back and forth in the electrolyte, but is, for example, less than 1500°C or less, preferably 1000°C or less.

The temperature at which the thermal power generation element actually generates electricity is determined by the temperature at which the first semiconductor in the first part produces a sufficient number of thermally excited electrons and holes to generate electricity. In addition to that, the temperature is determined by the material-specific easiness of electron transfer and the easiness of electron transfer at the interface due to the combination of the second part and the first part. However, these conditions are preferably in the range of L/IDT=1 to 20.

[2] Method for stabilizing power generation

In the method for stabilizing power generation of the present invention, a value of L/IDT (wherein L is a "shortest distance between the first part and the third part", and IDT is "ion diffusion thickness") is adjusted to 1 to 20, in the thermal power generation element that does not require a temperature gradient, wherein a first part comprising a semiconductor which produce thermally excited electron and hole, a second part comprising an electrolyte in which a charge transport ion pair can be moved therein, and a third part comprising a substance that is electrode, are in contact with each other in this order, and wherein a valance band potential of the semiconductor of the first part is positive with respect to a redox potential of a charge transport ion pair; and an ion which is more susceptible to oxidation among the two ions is oxidized at an interface between the first part and the second part; and an ion which is more susceptible to reduction among the two ions is reduced at an interface between the third part and the second part.

The shortest distance L between the first part and the third part, and ion diffusion thickness IDT can be measured and calculated as described in the above section "[1] thermal power generation element and thermal power generation battery."

Specifically, they can be measured and calculated by:

(1) a step of measuring the shortest distance L between the first part and the third part,
(2) a step of measuring alternating current impedance (AC impedance) of the thermal power generation element,
(3) a step of creating a fitting equation of the equivalent circuit from the obtained AC impedance values,
(4) a step of calculating an ion diffusion thickness IDT (corresponding to "$\delta$" in the following equation) using the obtained fitting equation and the following equation (II), [Equation 2]

$$Z_W = \frac{RT}{nFc^{bulk}} \frac{1}{nF\sqrt{j\omega D}} \tanh\left(\sqrt{\frac{j\omega}{D}}\delta\right) \qquad (\mathrm{I\,I})$$

(R: gas constant, $T$: temperature, $n$: number of reacting electrons, F: Faraday constant, $c^{bulk}$: bulk concentration of electrolyte ions, j: imaginary number, $\omega$: frequency, $D$: diffusion coefficient, $\delta$: ion diffusion thickness), and
(5) step of calculating L/IDT using the shortest distance L between the first part and the third part and the ion diffusion thickness IDT

(wherein L is a "shortest distance between the first part and the third part", and IDT is "ion diffusion thickness")

The ion diffusion thickness is a numerical value determined by the calculation depending on the "redox ion", "electrolyte", and "temperature" in the second part. However, the calculated values differ depending on models of the thermal power generation element on which the calculations are based. However, it is preferable to obtain it by measurement since different values may be calculated by different models. The "ion diffusion thickness" can be measured as follows. Therefore, it is considered that the actual ion diffusion thickness IDT can be obtained from the measured values by measuring the AC impedance of the actually fabricated thermal power generation element and creating a fitting equation of the equivalent circuit, which reflects the actual ion diffusion thickness.

In the method for stabilizing power generation of the present invention, the improvement of battery characteristics such as higher short-circuit current and/or higher discharged capacity are exhibited, by adjusting the shortest distance L between the first part and the third part so that L/IDT becomes "1-20."

The lower limit of L/IDT is 1 or more, 1.5 or more in one embodiment, and 2 or more in one embodiment. The upper limit of L/IDT is 20 or less, 15 or less in one embodiment, 10 or less in one embodiment, 8 or less in one embodiment, and 5 or less in one embodiment. The lower limits and the upper limits can be combined as appropriate. The shortest distance L between the first part and third part is adjusted so that L/IDT is in the above range.

<<Functions>>

A mechanism wherein the thermal power generation element of the present invention exhibits the excellent battery characteristics, has not been completely elucidated, but may be presumed to be as follows. However, the present invention is not limited by the following presumption.

In general, it is considered that the performance of thermal power generation element (batteries) is improved when the distance between the first part comprising the semiconductor and the third part comprising the substance that is electrode, is closer. However, in reality, there is an appropriate distance between the first part and the third parts that improves the power generation performance of the thermal power generation element (battery). It is not easy to logically explain that the appropriate distance between the first part and the third part is L/IDT=1-20. However, in the examples described below, excellent battery performances are obtained in the range of L/IDT=1-20 under different conditions of "redox ion", "electrolyte", and "temperature."

Therefore, it is presumed that the thermal power generation element exhibits excellent battery characteristics by setting L/IDT in an appropriate range.

EXAMPLES

The present invention now will be further illustrated by, but is by no means limited to, the following Examples.

« Example 1»

In this example, a sheet-type cell was prepared by using n-Si/Ge as the first part, PEG, and CuCl, CuCl$_2$, and LiCl as the second part, and FTO as the third part.

As the first part, an n-Si/Ge substrate of 1.5cm×2.5cm was prepared. As the third part, an FTO transparent electrode of 1.5cm×2.5cm was prepared. As the electrolyte of the second part, CuCl of 0.5 mmol/PEG(g), CuCl$_2$ of 0.5 mmol/PEG(g), and LiCl of 0.6 mmol/PEG(g) were mixed in polyethylene glycol (PEG). The sheet-type cell shown in the schematic diagram of Figure 4(a) was prepared by dropping the electrolyte of the second part onto the FTO transparent electrode of the third part, and then laminating the n-Si/Ge substrate of the first part.

Four sheet-type cells were prepared by making the distances between the first part and the third part are 85μm, 114μm, 228μm, and 342μm, respectively.

The battery characteristics of the resulting four cells were measured at 80°C. The results are shown in Figure 4(B). The open voltage decreased as the electrode spacing increased, and re-discharge did not occur.

« Example 2»

In this example, an interdigitated array cell was prepared using Ge as the first part, PEG, CuCl, CuCl$_2$, and LiCl as the second part, and Pt as the third part.

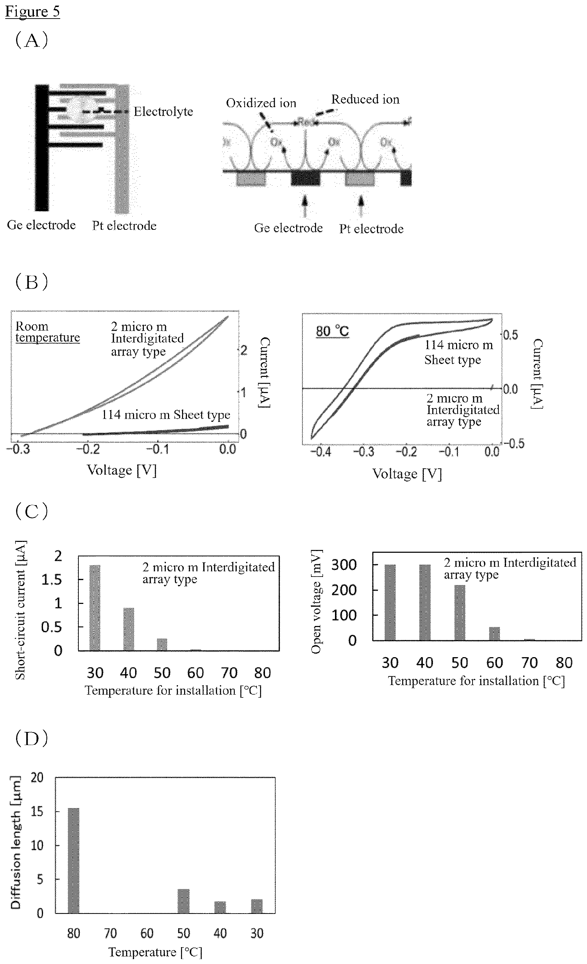

A Ge electrode as the first part and a Pt electrode as the third part were sputtered onto a quartz substrate in the form of an interdigitated array. On these electrodes, a mixture of PEG with 0.5mmol/PEG(g) of CuCl, 0.5mmmol/PEG(g) of CuCl$_2$, and 0.6mmol/PEG(g) of LiCl, was dropped as the second part (Figure 5A). The width of the interdigitated array electrode was 2μm. Battery characteristics were measured at 80°C and room temperature. No power was generated at 80°C, but power was generated at room temperature by lowering the temperature for installation (Fig. 5B and C).

The ion diffusion thickness depending on the temperature was shown in Figure 5D. The ion diffusion thickness decreases with decreasing temperature. The ion diffusion thickness at 40°C is slightly larger than that at 30°C, but this is because it is considered that the limitation of measurement of the ion diffusion thickness of 2μm or less in this measurement.

<<Measurement of L/IDT>>

L/IDTs were calculated from the shortest distance L between the first part and the third part and the ion diffusion thickness IDT for the four sheet-type cells (80°C) in Example 1 and the interdigitated array cell (30°C, 40°C, 50°C, and 60°C) in Example 2.

For each cell and temperature, the AC impedance was measured at an amplitude of 10 mV and a frequency of 7 MHz to 50 mHz. The measured values were plotted using Zplot (TOYO Co.), and fitting equations for the equivalent circuit were created. The resulting fitting equation and the following equation (II) were used to calculate the ion diffusion thickness IDT (corresponding to "δ" in the following equation).

[equation 3]

$$Z_w = \frac{RT}{nFc^{bulk}} \frac{1}{nF\sqrt{j\omega D}} \tanh\left(\sqrt{\frac{j\omega}{D}}\delta\right) \qquad (11)$$

(R: gas constant, $T$: temperature, $n$: number of reacting electrons, F: Faraday constant, $c^{bulk}$: bulk concentration of electrolyte ions, j: imaginary number, $\omega$: frequency, $D$: diffusion coefficient, $\delta$: ion diffusion thickness)

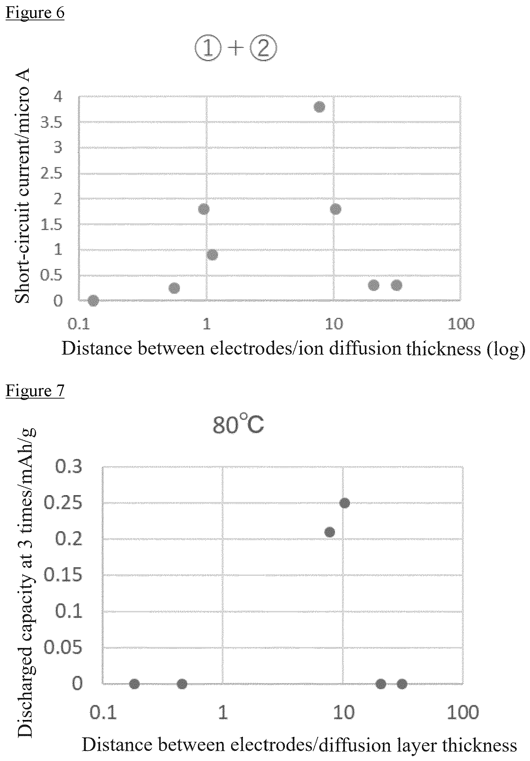

L/IDT was calculated from the resulting ion diffusion thickness IDT and the shortest distance L. The relationship between the short-circuit current and L/IDT is shown in Figure 6. No power was generated unless the shortest distance between the first part and the third part was at least 0.5 times larger than the ion diffusion thickness of the transport ion pair. The power generation became weak even when the distance was 20 times or more.

« Example 3»

In this example, a sheet-type cell was prepared by using n-Si/Ge as the first part, PEG, and CuCl, CuCl$_2$, and LiCl as the second part, and FTO as the third part.

Four sheet-type cells were prepared by repeating the procedure of Example 1.

« Example 4»

In this example, an interdigitated array cell was prepared using Ge as the first part, PEG, and CuCl, CuCl$_2$, and LiCl as the second part, and Pt as the third part.

Two interdigitated array cells were prepared by repeating the procedure of Example 2, except that the distances between electrodes are 2μm or 5μm.

<<Measurement of L/IDT and measurement of discharged capacity>>

For the four sheet-type cells in Example 3 and the two interdigitated array cells in Example 4, L/IDT was calculated by repeating the procedure of the above "Measurement of L/IDT".

The long-term discharged capacities of the four sheet cells in Example 3 and the two interdigitated array cells in Example 4 were measured. Each cell was discharged at 100 nA, while maintaining at 80°C. The cells were allowed to stand at room temperature for 2 hours, to recover. In addition, cells were repeatedly discharged at 100 nA, while maintaining at 80°C, and thereby the third discharged capacity was obtained. The relationship between the third discharged capacity and L/IDT for each cell is shown in Figure 7.

When L/IDT was between 1 and 20, the cells exhibited excellent discharged capacities.

« Example 5»

In this example, an interdigitated array cell was prepared using Ge as the first part, PEG, and CuCl, CuCl$_2$, and LiCl as the second part, and Pt as the third part.

Two interdigitated array cells were prepared by repeating the procedure of Example 4.

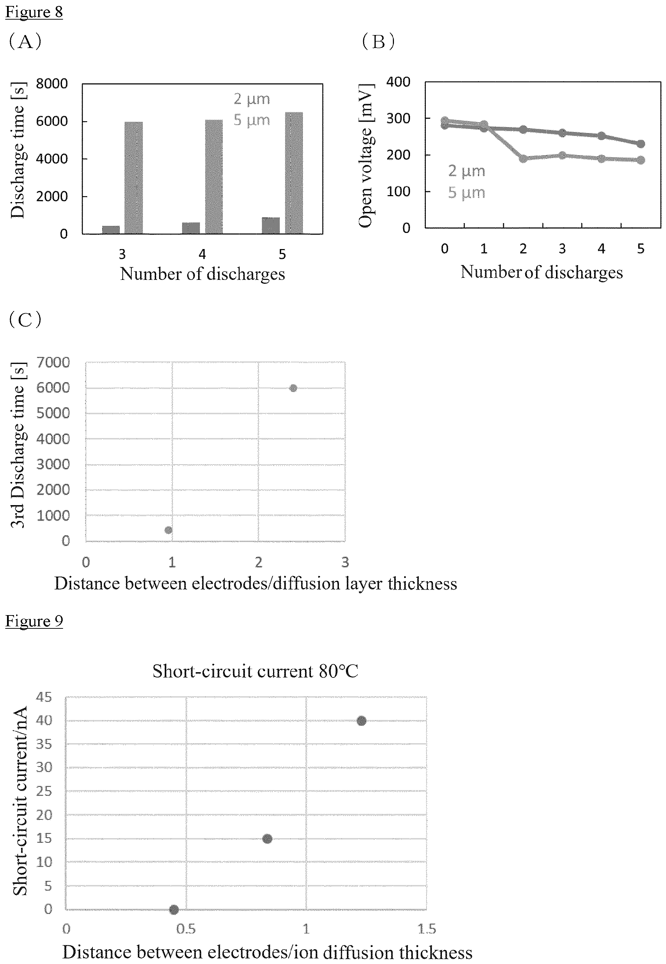

At room temperature, the open voltage value was maintained even as the number of discharges increased (Figure 8B). In addition, the discharge time for the electrode width of 5μm was longer even as the number of discharges increased (Figure 8A).

The discharge times were measured by switching off the circuit after the discharge was completed and then switching it on again after the voltage had stabilized for one hour.

L/IDT was calculated by repeating the procedure of the above "Measurement of L/IDT". The relationship between L/IDT and discharge time is shown in Figure 8C. When L/IDT was between 1 and 20, the discharge time was long.

« Example 6»

In this example, a sheet-type cell was prepared by using n-Si/Ge as the first part, EC, and NaI and $I_2$ as the second part, and FTO as the third part.

The procedure of Example 1 was repeated except that ethylene carbonate (EC), and 0.5 mol/EC(g) of NaI and 0.05 mmol/EC(g) of $I_2$ were used as the electrolyte of the second part, to prepare three sheet-type cells with 114μm of electrode-to-electrode distances) and different polyiodine chain growth times (0, 7, 14, and 19 days).

The relationship between the short-circuit current and L/IDT at 80°C is shown in Figure 9. The short-circuit current was high when L/IDT was 1 to 20.

« Example 7»

In this example, a sheet-type cell was prepared by using $TiO_2/Ag_2S$ as the first part, DMSO, and Cp(arene)Fe and $LiClO_4$ as the second part, and PtTi/PEN as the third part.

The procedure of Example 1 was repeated, except that $TiO_2/Ag_2S$ was used as the first part, Smmol of Cp(arene)Fe/DMSO(g) and 0.4mol of $LiClO_4$/DMSO(g) were used as the second part, and PtTi/PEN was used as the third part, to prepare two sheet-type cells with an inter-electrode distance of 113μm. The IDTs were measured before and during discharge.

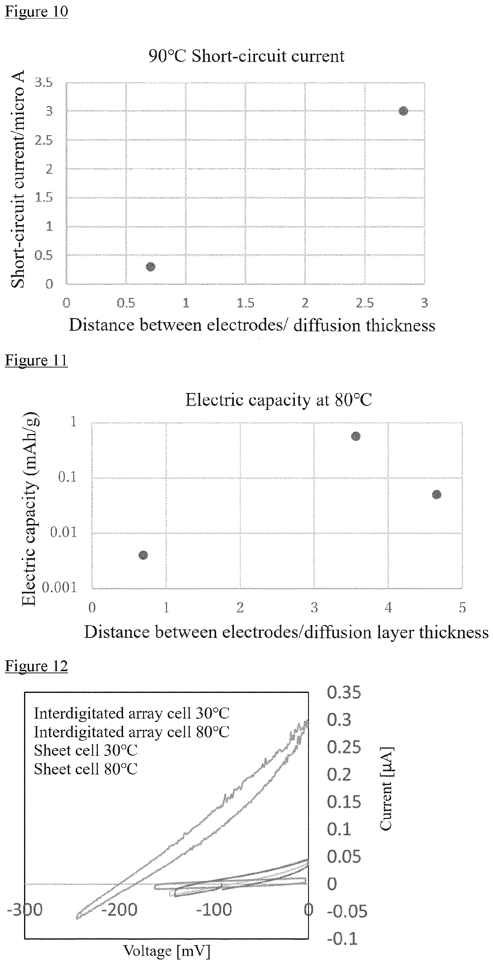

The relationship between the short-circuit current at 90°C and L/IDT is shown in Figure 10. The short-circuit current was high when L/IDT was 1 to 20.

« Example 8»

In this example, a sheet-type cell was prepared by using n-Si/Ge as the first part, DMSO, and NaI and $I_2$ as the second part, and FTO as the third part.

The procedure of Example 1 was repeated, except that 0.25mol of NaI/DMSO(g) and 0.025mol of $I_2$/DMSO(g);0.5mol of NaI/DMSO(g) and 0.05mol of $I_2$/DMSO(g); or 1.0mol of NaI/DMSO(g) and 0.1mol of $I_2$/DMSO(g) were used as the second part, to prepare three sheet-type cells with 114μm of electrode-to-electrode distance.

The relationship between the electric capacity at 80°C and L/IDT is shown in Figure 11. When L/IDT was 1-20, the electric capacity was high.

« Example 9»

In this example, the effect of the shortest distance between the first part and the third part on the dischargeable temperature of the thermal power generation element of the present invention, was examined.

$I_2$ of 0.05 mol/L (PEGDME) and NaI of 0.5 mol/L (PEGDME) were mixed with PEGDME, to prepare as the second part.

A Ge electrode as the first part and a Pt electrode as the third part were sputtered onto a quartz substrate in the form of an interdigitated array at intervals of 2μm, and electrolyte was dropped on the electrodes. A 1.5cm×2.5cm of n-Si/Ge substrate as the first part and a 1.5x2.5cm FTO transparent electrode as the third part were used, and the second part was sandwiched between them with a 114μm thick. A battery characteristics thereof were measured while holding them at 30°C and 80°C (Figure 12). (diffusion distance 48.6, distance between electrodes 114μm)

INDUSTRIAL APPLICABILITY

The thermal power generation element and thermal power generation module comprising the same of the present invention can be used for
batteries, small portable power generation devices, geothermal power generation, thermal power generation using waste heat from automobiles, and thermal power generation using waste heat from electric substations, steel furnaces, or waste incineration plants.

REFERENCE SIGNS LIST

1 First part;
2 Second part;
3 Third part;

**Claims**

1. A thermal power generation element that does not require a temperature gradient, wherein a first part comprising a semiconductor which produce thermally excited electron and hole, a second part comprising an electrolyte in which an charge transport ion pair can be moved therein, and a third part comprising a substance that is an electrode, are in contact with each other in this order, and wherein a valance band potential of the semiconductor of the first part is positive with respect to a redox potential of a charge transport ion pair; and an ion which is more susceptible to oxidation among the two ions is oxidized at an interface between the first part and the second part; and an ion which is more susceptible to reduction among the two ions is reduced at an interface between the third part and the second part; and wherein the thermal power generation element satisfies the following formula (I):

$$L/IDT = 1\text{-}20 \quad (I)$$

wherein L is a "shortest distance between the first part and the third part", and IDT is "ion diffusion thickness."

2. The thermal power generation element according to claim 1, wherein the first part, the second part and the third part are layered.

3. The thermal power generation element according to claim 1, wherein the first part, the second part and the third part are concentrically located.

4. A thermal power generation device comprising the thermal power generation element according to any one of claims 1 to 3.

5. A thermal power generation battery comprising the thermal power generation element according to any one of claims 1 to 3.

6. A thermal power generation module comprising the thermal power generation element according to any one of claims 1 to 3.

7. A method for stabilizing power generation, **characterizing in that** a value of L/IDT (wherein L is a "shortest distance between the first part and the third part", and IDT is "ion diffusion thickness") is adjusted to 1 to 20, in the thermal power generation element that does not require a temperature gradient, wherein a first part comprising a semiconductor which produce thermally excited electron and hole, a second part comprising an electrolyte in which a charge transport ion pair can be moved therein, and a third part comprising a substance that is electrode, are in contact with each other in this order, and wherein a valance band potential of the semiconductor of the first part is positive with respect to a redox potential of a charge transport ion pair; and an ion which is more susceptible to oxidation among the two ions is oxidized at an interface between the first part and the second part; and an ion which is more susceptible to reduction among the two ions is reduced at an interface between the third part and the second part.

Figure 1

| First part | Second part | Third part |

Figure 2

(A)

(B)

(C)

(D)

(E)

Figure 3

Figure 4

(A)

(B)

(C)

Figure 5

(A)

Electrolyte

Ge electrode    Pt electrode

Oxidized ion    Reduced ion

Ge electrode    Pt electrode

(B)

Room temperature    2 micro m Interdigitated array type

Current [μA]

114 micro m Sheet type

Voltage [V]

80 °C

114 micro m Sheet type

2 micro m Interdigitated array type

Current [μA]

Voltage [V]

(C)

Short-circuit current [μA]

2 micro m Interdigitated array type

Temperature for installation [°C]

Open voltage [mV]

2 micro m Interdigitated array type

Temperature for installation [°C]

(D)

Diffusion length [μm]

Temperature [°C]

Figure 6

Distance between electrodes/ion diffusion thickness (log)

Figure 7

Distance between electrodes/diffusion layer thickness

Figure 8

（A）

（B）

（C）

Figure 9

Figure 10

## 90°C Short-circuit current

Distance between electrodes/ diffusion thickness

Figure 11

## Electric capacity at 80°C

Distance between electrodes/diffusion layer thickness

Figure 12

Interdigitated array cell 30°C
Interdigitated array cell 80°C
Sheet cell 30°C
Sheet cell 80°C

Voltage [mV]

**EP 4 307 400 A1**

<div align="center">

**INTERNATIONAL SEARCH REPORT**

</div>

| | International application No. |
|---|---|
| | **PCT/JP2022/009619** |

| A. | CLASSIFICATION OF SUBJECT MATTER |
|---|---|

*H01L 37/00*(2006.01)i; *H02N 11/00*(2006.01)i
FI:   H01L37/00; H02N11/00 A

According to International Patent Classification (IPC) or to both national classification and IPC

| B. | FIELDS SEARCHED |
|---|---|

Minimum documentation searched (classification system followed by classification symbols)

H01L37/00; H02N11/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2021-005651 A (SANOH INDUSTRIAL CO., LTD.) 14 January 2021 (2021-01-14) paragraphs [0014]-[0028], fig. 1-2 | 1-7 |
| A | WO 2020/031992 A1 (TOKYO INST. OF TECHNOLOGY) 13 February 2020 (2020-02-13) paragraphs [0010]-[0034], [0042]-[0043] | 1-7 |
| A | WO 2017/038988 A1 (TOKYO INST. OF TECHNOLOGY) 09 March 2017 (2017-03-09) entire text, all drawings | 1-7 |
| A | WO 2012/140856 A1 (UNIV. OF TSUKUBA) 18 October 2012 (2012-10-18) entire text, all drawings | 1-7 |
| A | US 2021/0020362 A1 (CHANG, Yu-Che) 21 January 2021 (2021-01-21) entire text, all drawings | 1-7 |
| A | WO 2001/071821 A1 (SHIN-ETSU CHEMICAL CO., LTD.) 27 September 2001 (2001-09-27) entire text, all drawings | 1-7 |

☑ Further documents are listed in the continuation of Box C.       ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **25 May 2022** | **07 June 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2022/009619**

**C. DOCUMENTS CONSIDERED TO BE RELEVANT**

| Category* | Citation of document, with indication, where appropriate, of the relevant passages | Relevant to claim No. |
|---|---|---|
| A | JP 8-306964 A (HASEGAWA, Jinichiro) 22 November 1996 (1996-11-22) entire text, all drawings | 1-7 |
| A | JP 4-190572 A (NIPPON TELEGR. & TELEPH. CORP.) 08 July 1992 (1992-07-08) entire text, all drawings | 1-7 |

Form PCT/ISA/210 (second sheet) (January 2015)

INTERNATIONAL SEARCH REPORT
Information on patent family members

International application No.

**PCT/JP2022/009619**

| Patent document cited in search report | | | Publication date (day/month/year) | Patent family member(s) | | | Publication date (day/month/year) |
|---|---|---|---|---|---|---|---|
| JP | 2021-005651 | A | 14 January 2021 | WO | 2020/262171 | A1 | |
| WO | 2020/031992 | A1 | 13 February 2020 | US | 2021/0296552 | A1 | |
| | | | | paragraphs [0032]-[0094], [0118]-[0126] | | | |
| | | | | CN | 112689907 | A | |
| | | | | TW | 202027306 | A | |
| WO | 2017/038988 | A1 | 09 March 2017 | TW | 201725765 | A | |
| WO | 2012/140856 | A1 | 18 October 2012 | (Family: none) | | | |
| US | 2021/0020362 | A1 | 21 January 2021 | CN | 112234220 | A | |
| | | | | TW | 202105779 | A | |
| WO | 2001/071821 | A1 | 27 September 2001 | US | 2002/0180042 | A1 | |
| | | | | entire text, all drawings | | | |
| | | | | WO | 2001/071822 | A1 | |
| JP | 8-306964 | A | 22 November 1996 | (Family: none) | | | |
| JP | 4-190572 | A | 08 July 1992 | (Family: none) | | | |

Form PCT/ISA/210 (patent family annex) (January 2015)

**REFERENCES CITED IN THE DESCRIPTION**

**Patent documents cited in the description**

- JP 2010147236 A
- JP 2003219669 A
- WO 2017038988 A
- WO 2020031992 A

**Non-patent literature cited in the description**

- *Renewable and Sustainable Energy Reviews (Holland),* 2014, vol. 33, 371